# EUROPEAN PATENT APPLICATION

(11) **EP 3 404 783 A1**
(43) Date of publication of application: **21.11.2018**
(21) Application number: 17738320.5
(22) Date of filing: 05.01.2017
(51) Int. Cl.: H02B 1/28, F24F 7/04, F24F 7/06, F24F 13/14, H05K 7/20

(54) **SWITCHING DEVICE**

(30) Priority: 12.01.2016 JP 2016003137
(71) Applicant: Hitachi Industrial Equipment Systems Co., Ltd., Tokyo 101-0022 (JP)
(72) Inventor: HOSONO, Takafumi, Tokyo 100-8280 (JP); HORII, Chihiro, Tokyo 100-8280 (JP); OKADA, Naoya, Tokyo 100-8280 (JP); TSUCHIYA, Kenji, Tokyo 100-8280 (JP); YAMAUCHI, Yohei, Tokyo 100-8280 (JP)
(74) Representative: MERH-IP Matias Erny Reichl Hoffmann Patentanwälte PartG mbB
(86) International application number: PCT/JP2017/000108
(87) International publication number: WO 2017/122565

(57) **Abstract**

The present invention provides a switching device that is adapted to prevent high-temperature, high-pressure gas from flowing out through ventilation aperture outside when internal arcing occurs and that can be designed to be smaller. The switching device of the present invention is characterized as follow: the switching device is provided with a housing containing at least a switch unit therein; and a ventilator provided on an upper part of the housing and communicating with the housing via an opening portion, the ventilator is provided with a ventilation aperture through which air is discharged outside in normal operation, the air being the external air flowing in through an air inlet provided at the lateral lower part of the housing and being warmed through cooling the switch unit; and a pressure relief plate which is installed to cover the opening portion formed at the top of the ventilator and through which high-temperature, high-pressure gas generated when internal arcing occurs is released outside in the event of the internal arcing while the pressure relief plate is opened by the gas pressure, and a shield plate to prevent high-temperature, high-pressure gas generated when internal arcing occurs from flowing out through the ventilation aperture is installed at an inner side of the ventilation aperture.

## Description

### Technical Field

The present invention relates to a switching device and, particularly, to a switching device that is advantageously suited for such device having a pressure relief plate for releasing pressure when internal arcing occurs.

### Background Art

Commonly, a switch unit including, inter alia, a switchgear, installed inside the housing of a switching device, generates heat during usage (in normal operation), so it is required to discharge that heat outside. In addition, in case internal arcing should occur along with an internal short circuit (interphase short circuit) accident, countermeasures against pressure rise upon occurrence of such accident should be taken for the switch unit such as a switchgear. Usually, countermeasures are taken to release pressure when internal arcing occurs by providing a pressure discharge board at a ceiling of the housing that contains the switch unit such as a switchgear.

Such a device that discharges heat generated by a switch unit in normal operation and is provided with a pressure discharge board as countermeasures against pressure rise when internal arc occurs is described in Patent Literature 1.

In Figs. 5, 6, and 7 of Patent Literature 1, an electric room exhaust outlet is provided in the ceiling positioned above a switchgear of an electric room housing, the electric room exhaust outlet has a tubular portion projecting upward in a chimney form farther up from the ceiling and opening upward, and an electric room pressure discharge board is provided to cover up the opening of the tubular portion from above. It is described that the electric room pressure discharge board is anchored by connecting with a connecting member to the exterior surface of the ceiling of the electric room housing, the tubular portion has a flange whose upper surface is open outward in a horizontal direction, and a ventilation aperture (a plurality of slits or circular holes) is formed in an upper part of the lateral surface of the tubular portion.

When in normal operation, air warmed by heat that is generated by electric device components within the switchgear is discharged outside of the electric room through the ventilation aperture of the tubular portion of the electric room exhaust outlet. In the meantime, when internal arcing occurs, the electric room pressure discharge board is opened upward by gas pressure and high-temperature, high-pressure gas is discharged outside of the electric room through an opening created between the upper surface of the flange of the tubular portion and the under surface of the electric room pressure discharge board.

### Citation List

### Patent Literature

PTL 1: Published PCT International Application No. WO 2013/99393

### Summary of Invention

### Technical Problem

However, in Patent Literature 1 mentioned above, the electric room exhaust outlet has the tubular portion that projects upward in a chimney form farther up from the ceiling of the electric room housing and has a ventilation aperture (a plurality of slits or circular holes) formed as an opening portion in an upper part of its lateral surface and the electric room pressure discharge board is provided to cover up the opening portion from above. There is a possibility that high-temperature, high-pressure gas flows out through the ventilation aperture (the plurality of slits or circular holes) outside when internal arcing occurs. Not only because there is the tubular portion but because it is necessary to open the electric room pressure discharge board upward by gas pressure and form an opening created between the upper surface of the flange of the tubular portion and the under surface of the electric room pressure discharge board, it is likely that a height dimension of the housing increases, thereby enlarging the entire device size.

The present invention has been developed in view of the above-noted points and its object is to provide a switching device that is adapted to prevent high-temperature, high-pressure gas from flowing out through the ventilation aperture outside when internal arcing occurs and that can be designed to be smaller.

### Solution to Problem

In order to achieve the above-noted object, a switching device of the present invention is characterized as follow: the switching device is provided with a housing containing at least a switch unit therein; and a ventilator provided on an upper part of the housing and communicating with the housing via an opening portion, the ventilator is provided with a ventilation aperture through which air is discharged outside in normal operation, the air being the external air flowing in through an air inlet provided at the lateral lower part of the housing and being warmed through cooling the switch unit; and a pressure relief plate which is installed to cover the opening portion formed at the top of the ventilator and through which high-temperature, high-pressure gas generated when internal arcing occurs is released outside in the event of the internal arcing while the pressure relief plate is opened by the gas pressure, and a shield plate to prevent high-temperature, high-pressure gas generated when internal arcing occurs from flowing out through the ventilation aperture is installed at an inner side of the ventilation aperture.

### Advantageous Effects of Invention

According to the present invention, it is possible to obtain a switching device adapted to prevent high-temperature, high-pressure gas from flowing out through the ventilation aperture outside when internal arcing occurs and that can be designed to be smaller.

### Brief Description of Drawings

Figure 1 is a cross-sectional diagram depicting an overall structure of Example 1 of a switching device of the present invention.
Figure 2 depicts an outline structure of a ventilator in Fig. 1 and schematically illustrates how the ventilator is in normal operation.
Figure 3 depicts the outline structure of the ventilator in Fig. 1 and schematically illustrates how the ventilator is when internal arcing occurs.
Figure 4 depicts an outline structure of the ventilator in Example 2 of the switching device of the present invention and schematically illustrates how the ventilator is when internal arcing occurs.

### Description of Embodiments

In the following, a switching device of the present invention is described based on Examples depicted in the drawings. Now, in each of the Examples, identical reference numerals are used to denote identical components.

### Example 1

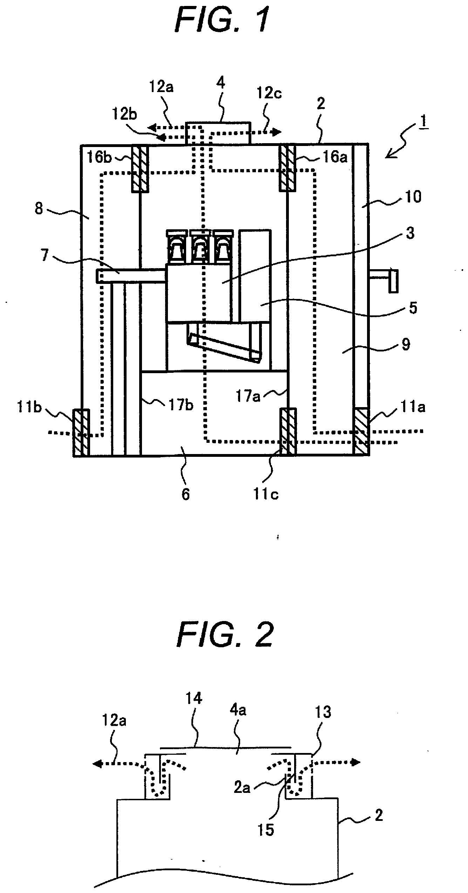

Figs. 1, 2, and 3 depict an overall structure of Example 1 of a switching device of the present invention.

As depicted in Fig. 1, a switching device 1 of the present Example is configured such that at least a switch unit 3 is contained inside a housing 2 and, on a top of the housing 2, the switching device has a ventilator 4 communicating with the housing 2 via an opening portion 4a.

To illustrate more specifically, in the switching device 1 of the present Example, the housing 2 is divided into a breaker room 6 in which a switch unit 3, such as a switchgear, and an actuator 5 which actuates the switch unit 3 among others are contained, a cable room 8 in which a cable 7 which is connected to the switch unit 3 is contained, and a control room 9 in which a control device (not depicted) is contained. For the switching device 1 depicted in Fig. 1, a right hand in Fig. 1 is its front where an opening/closing door 10 provided and a suite of instruments and an operating unit are arranged.

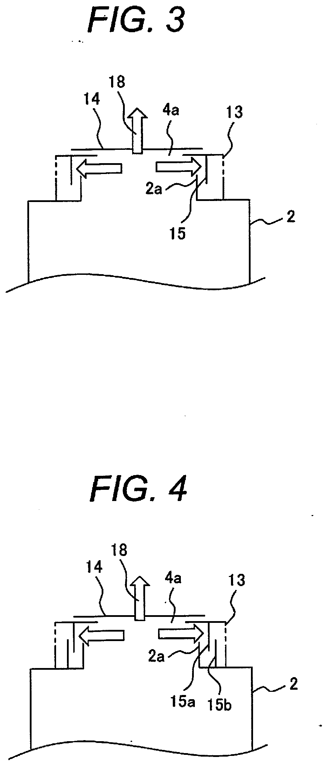

In the meantime, as depicted in Figs. 2 and 3, the ventilator 4 is configured including a ventilation aperture (e.g., a plurality of small holes or slits) 13 and a pressure relief plate 14. Through the ventilation aperture 13, air (an arrow 12a) which is external air flowing in through an air inlet 11a (see Fig. 1) provided at the lateral lower part of the housing 2 (at the bottom of the opening/closing door 10) and is warmed through cooling the switch unit 3 is discharged outside in normal operation. The pressure relief plate 14 is installed to cover the opening portion 4a formed at the top of the ventilator 4. Through the pressure relief plate 14, high-temperature, high-pressure gas 18 generated when internal arcing occurs is released outside in the event of internal arcing while the pressure relief plate 14 is opened by the gas pressure.

In addition, an air inlet 11b allowing external air to flow in is provided at the lower part of the cable room 8 and an air inlet 11c which directs air flowing in through the air inlet 11a to the internal space of the breaker room 6 is provided in a position facing the air inlet 11a on a partition frame 17a between the breaker room 6 and the control room 9. In the meantime, an exhaust outlet 16b which directs external air flowing into the cable room 8 through the air inlet 11b to the ventilator 4 through the breaker room 6 is provided at the upper part of a partition frame 17b between the breaker room 6 and the cable room 8 and an exhaust outlet 16a which directs external air flowing into the control room 8 through the air inlet 11a to the ventilator 4 through the breaker room 6 is provided at the upper part of the partition frame 17a between the breaker room 6 and the control room 9. In addition, the aforementioned pressure relief plate 14 has a weakened portion (allowing gas to pass through easily) formed therein to allow high-temperature, high-pressure gas 18 to be released outside and is fixated with a bolt or the like to cover the opening portion 4a formed at the top of the ventilator 4.

In the present Example, a shield plate 15 to prevent high-temperature, high-pressure gas 18 generated when internal arcing occurs from flowing out through the ventilation aperture 13 is installed at an inner side of the ventilation aperture 13.

The shield plate 15 has size enough to block the ventilation aperture 13 and it is screwed or welded to a ceiling plate at the top of the ventilator 4, and is provided in a lapped position in a horizontal direction (a transverse direction in Fig. 3) with respect to a part of a tubular portion 2a which defines the opening portion 4a via which the housing 2 communicates with the ventilator 4.

Then, descriptions are provided about a flow of air in normal operation, a flow of high-temperature, high-pressure gas generated when internal arcing occurs, and how the pressure relief plate 14 and the shield plate 15 work when internal arcing occurs in the switching device 1 of the present Example configured as described hereinbefore.

First, in normal operation, as depicted in Figs. 1 and 2, external air flowing in through the air inlet 11a is directed to the breaker room 6 by the air inlet 11c and cools the switch unit 3 and warmed air (an arrow 12a) after cooling it is discharged outside via the ventilation aperture 13. Also, external air flowing into the control room 9 through the air inlet 11a cools the internal space of the control room 9 and warmed air (an arrow 12c) after cooling it is discharged outside via the exhaust outlet 16a and the ventilation aperture 13. Moreover, external air flowing into the cable room 8 through the air inlet 11b cools the internal space of the cable room 8 and warmed air (an arrow 12b) after cooling it is discharged outside via the exhaust outlet 16b and the ventilation aperture 13.

In the meantime, when internal arcing occurs, the weakened portion of the pressure relief plate 14 is destroyed and opened upward by gas pressure and high-temperature, high-pressure gas 18 is released outside of the housing 2 through this opened portion. At this time, because the shield plate 15 is provided at the inner side of the ventilation aperture 13 in the present Example, high-temperature, high-pressure gas 18 flowing toward the ventilation aperture 13 is blocked by the shield plate 15 just before the ventilation aperture 13; therefore, it is possible to prevent discharge of the gas outside of the housing 2.

Therefore, according to the present Example, it is possible to prevent high-temperature, high-pressure gas 18 from flowing out through the ventilation aperture 13 outside when internal arcing occurs. In addition, it is not required to create an opening between the upper surface of the flange of the tubular portion and the under surface of the electric room pressure discharge board so that the electric room pressure discharge board can be opened upward by gas pressure, as is done in the related art. So, it is not required to increase the height dimension of the housing 2 and there is no possibility of enlarging the entire device size; therefore, the switching device can be designed to be smaller.

### Example 2

Fig. 4 depicts an outline structure of the ventilator 4 in Example 2 of a switching device of the present invention; this figure corresponds to Fig. 3 for Example 1.

In the present Example depicted in this figure, two shield plates 15a, 15b (the number of these plates may be on the order of two to five, though there are two ones in the present Example) are installed in a staggered fashion in a horizontal direction (a transverse direction in Fig. 4) .

One shield plate 15a of them has size enough to block the ventilation aperture 13 and it is screwed or welded to a ceiling plate at the top of the ventilator 4, and is provided in a lapped position with respect to a part of the tubular portion 2a which defines the opening portion 4a via which the housing 2 communicates with the ventilator 4. The other shield plate 15b has size enough to block the ventilation aperture 13 and it is screwed or welded to a ceiling plate of the housing 2, and is provided in a lapped position in a horizontal direction (a transverse direction in Fig. 4) with respect to a part of the shield plate 15a.

Even the present Embodiment as described above, of course, can provide the same advantageous effect as with Example 1 and in addition, it is possible to enhance the effect of shielding the high-temperature, high-pressure gas 18 by providing a plurality of shield plates just before the ventilation aperture 13 and reliability is improved.

Now, the present invention is not limited to the described Examples and various modifications are included therein. For example, the foregoing Examples are those described in detail to explain the present invention clearly and the present invention is not necessarily limited to those including all components described. In addition, a subset of the components of an Example can be replaced by components of another Example. To the components of an Example, components of another Example can be added. For a subset of the components of each Example, other components can be added to the subset or the subset can be removed or replaced by other components.

### Reference Signs List

1... switching device,
2... housing,
2a... tubular portion,
3... switch unit,
4... ventilator,
4a... opening portion,
5... actuator,
6... breaker room,
7... cable,
8... cable room,
9... control room,
10... opening/closing door,
11a, 11b, 11c... air inlet,
12a, 12b, 12c... warmed air flow,
13... ventilation aperture,
14... pressure relief plate,
15, 15a, 15b... shield plate,
16a, 16b... exhaust outlet,
17a, 17b... partition frame,
18... high-temperature, high-pressure gas

## Claims

1. A switching device provided with a housing containing at least a switch unit therein; and a ventilator provided on an upper part of the housing and communicating with the housing via an opening portion,
wherein the ventilator is provided with a ventilation aperture through which air is discharged outside in normal operation, the air being the external air flowing in through an air inlet provided at the lateral lower part of the housing and being warmed through cooling the switch unit; and a pressure relief plate which is installed to cover the opening portion formed at the top of the ventilator and through which high-temperature, high-pressure gas generated when internal arcing occurs is released outside in the event of the internal arcing while the pressure relief plate is opened by the gas pressure, and wherein a shield plate to prevent high-temperature, high-pressure gas generated when internal arcing occurs from flowing out through the ventilation aperture is installed at an inner side of the ventilation aperture.

2. The switching device according to claim 1, wherein the shield plate has size enough to block the ventilation aperture.

3. The switching device according to claim 1 or 2, wherein a plurality of the shield plates are installed.

4. The switching device according to claim 3, wherein the plurality of the shield plates are installed in a staggered fashion in a horizontal direction.

5. The switching device according to any one of claims 1 to 4, wherein the ventilation aperture includes a plurality of small holes or slits.
